Europäisches Patentamt

(19) European Patent Office

Office européen des brevets

(11) **EP 1 204 873 B1**

(12) **EUROPÄISCHE PATENTSCHRIFT**

(45) Veröffentlichungstag und Bekanntmachung des Hinweises auf die Patenterteilung:
**20.07.2005 Patentblatt 2005/29**

(51) Int Cl.$^7$: **G01R 19/00**

(21) Anmeldenummer: **00956140.8**

(86) Internationale Anmeldenummer:
**PCT/DE2000/002691**

(22) Anmeldetag: **10.08.2000**

(87) Internationale Veröffentlichungsnummer:
**WO 2001/013131 (22.02.2001 Gazette 2001/08)**

(54) **SCHALTUNG UND VERFAHREN ZUR BESTIMMUNG DES OFFSETFEHLERS BEI EINER OFFSETFEHLERBEHAFTETEN MESSUNG DES SPULENSTROMS EINES ELEKTROMAGNETISCHEN STELLGERÄTES**

CIRCUIT AND METHOD FOR DETERMINING THE OFFSET ERROR OF A MEASUREMENT OF THE COIL CURRENT OF AN ELECTROMAGNETIC ACTUATOR THAT IS SUBJECT TO SUCH AN OFFSET ERROR

CIRCUIT ET PROCEDE POUR DETERMINER L'ERREUR DUE AU DECALAGE LORS D'UNE MESURE, AFFECTEE PAR UN DECALAGE, DU COURANT DE BOBINE D'UN ACTIONNEUR ELECTROMAGNETIQUE

(84) Benannte Vertragsstaaten:
**DE FR GB**

(30) Priorität: **16.08.1999 DE 19938779**

(43) Veröffentlichungstag der Anmeldung:
**15.05.2002 Patentblatt 2002/20**

(73) Patentinhaber: **SIEMENS AKTIENGESELLSCHAFT
80333 München (DE)**

(72) Erfinder:
• **QUEISSER, Frank**
  **D-93055 Regensburg (DE)**
• **VOGT, Thomas**
  **D-93049 Regensburg (DE)**
• **FRANZ, Thomas**
  **D-90431 Nürnberg (DE)**

(56) Entgegenhaltungen:
**DE-A- 3 429 854          DE-A- 3 942 167**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 1 204 873 B1

**Beschreibung**

Die Erfindung betrifft eine Schaltung und ein Verfahren zur Bestimmung des Offsetfehlers bei einer offsetbehafteten Messung des Spulenstroms eines elektromagnetischen Stellgerätes.

Elektromagnetische Stellgeräte, die beispielsweise ein Gaswechselventil einer Brennkraftmaschine antreiben, weisen üblicherweise mindestens eine Spule auf. Ein elektromagnetisches Stellgerät für Gaswechselventile ist beispielsweise aus der DE 297 12 502 U1 oder EP 0 724 067 A1 bekannt. Es weist eine zwischen einer geschlossenen und einer offenen Stellung liegende Ruhestellung auf, aus der es mittels Elektromagneten ausgelenkt werden kann.

Um ein von diesem Stellgerät angetriebenes Gaswechselventil zu öffnen oder zu schließen, wird die der jeweiligen Endstellung zugeordnete Spule bestromt, wobei der erforderliche Strom in der Fangphase größer ist als in der Haltephase, in der das Gaswechselventil in der Endstellung des Stellgerätes gehalten wird.

Wird der entsprechende Elektromagnet dabei einfach mit Strom beaufschlagt, so trifft der Ventilteller des Gaswechselventils mit hoher Geschwindigkeit auf den Ventilsitz, was Lärm erzeugt und verschleißfördernd ist. Um dies zu vermeiden, muss die Auftreffgeschwindigkeit verringert werden. Dazu wird die Bestromung geeignet geregelt.

Dazu ist es bei elektromagnetischen Stellgeräten erforderlich, den Spulenstrom zu messen.

Dies kann beispielsweise durch Potentialabgriffe an einem mit der Spule in Reihe geschalteten Widerstand erfolgen. Mittels des Ohmschen Gesetzes lässt sich dann aus dem Wert des Widerstandes sowie dem gemessenen Spannungsabfall der Strom errechnen.

Üblicherweise wird der Spannungsabfall mit einer Analogschaltung erfasst. Bei einer solchen Analogschaltung ist ein Offsetfehler unvermeidlich, d.h. die gemessene Spannung ist zu groß oder zu klein. Eine Messeinrichtung, die eine automatische Offsetspannungskompensation vornimmt, ist zwar aus DE 34 29 854 A1 bekannt, jedoch benötigt man dazu eine besonderen Hybridbaustein, was relativ aufwendig ist. Eine ähnlich wirkende Schaltungsanordnung ist aus DE 34 48 182 C2 bekannt. Dabei wird ein Speicherbaustein zur Offsetkompensation verwendet.

Die Druckschrift DE 39 42 167 A1 offenbart eine Fehlererfassungseinrichtung für elektrische Schaltungen. Hierbei erfasst ein Stromsensor den Strom eines an eine elektrische Schaltung angelegten Steuersignals. Von dem Strom des Steuersignals wird ein Offsetstrom subtrahiert, um einen Betriebsstrom zu bilden. Dabei wird der Offsetstrom stets vor Erzeugung des Steuersignals bestimmt. Hierfür ist zur Bestimmung des Offsetstroms eine Offsetstromaktualisierungseinheit 35 vorgesehen.

Der Erfindung liegt die Aufgabe zugrunde, eine Schaltung eines elektromagnetischen Stellgeräts bzw. ein Verfahren zur Bestimmung des Offsetfehlers bei einer offsetfehlerbehafteten Messung des Spulenstroms eines elektromagnetischen Stellgeräts zu schaffen, so dass keine besonderen Bausteine benötigt werden.

Diese Aufgabe wird durch die in den Ansprüchen 1 und 5 gekennzeichnete Erfindung gelöst.

Die Erfindung geht von der Erkenntnis aus, dass es eine Endstellung des Stellgerätes gibt, in der eine Spule unbestromt ist. Misst man zu diesem Zeitpunkt den Spulenstrom, lässt sich daraus der Offsetfehler ermitteln.

Bei einem Stellgerät, das beispielsweise zum Antrieb eines Gaswechselventils verwendet wird und bei dem zum Öffnen oder Schließen des Gaswechselventils die der entsprechenden Endstellung zugeordnete Spule zuerst mit einem Fangstrom und dann mit einem Haltestrom bestromt wird, erfolgt die Bestimmung des Offsetfehlers vorzugsweise an derjenigen Spule, die der anderen Endstellung zugeordnet ist, dann, wenn die bestromte Spule sich in der Haltephase befindet. Zu diesem Zeitpunkt ist nämlich sichergestellt, dass die Spule, bei deren Schaltung der Offsetfehler bestimmt wird, nicht bestromt ist. In der Fangphase ist dies nicht sichergestellt, da beispielsweise der Strom aus seiner vorherigen Haltephase noch abklingen kann bzw. u.U. zum verzögerten Überführen des Stellgerätes in die andere Endstellung während der Fangphase die Spule noch kurzzeitig bestromt wird.

Vorteilhafte Ausgestaltungen der Erfindung sind in den Unteransprüchen gekennzeichnet.

Ein Ausführungsbeispiel der Erfindung ist nachstehend anhand der Zeichnungen näher erläutert. Es zeigt:

Fig. 1 einen Schnitt durch ein Stellgerät für ein Gaswechselventil einer Brennkraftmaschine,

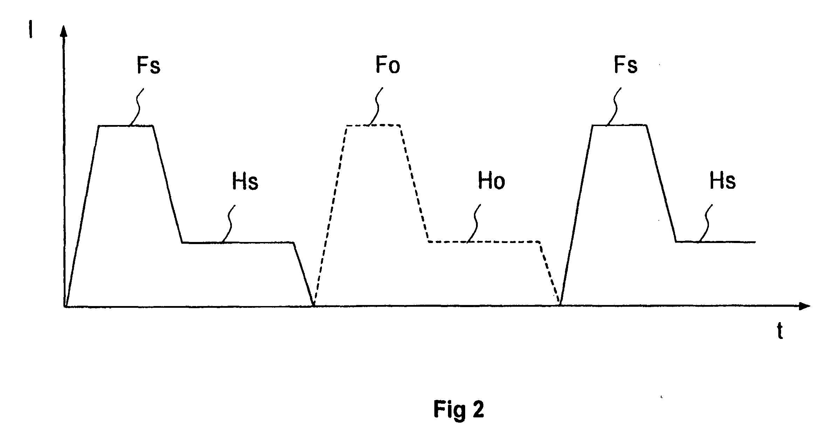

Fig. 2 die Zeitreihe des Stromverlaufes durch die zwei Spulen der Fig. 1,

Fig. 3 eine Schaltung zum Erfassen des Spulenstroms durch eine Spule und

Fig. 4 die beim Betrieb des Gaswechselventils durchlaufenen Zustände in einem Flussdiagramm.

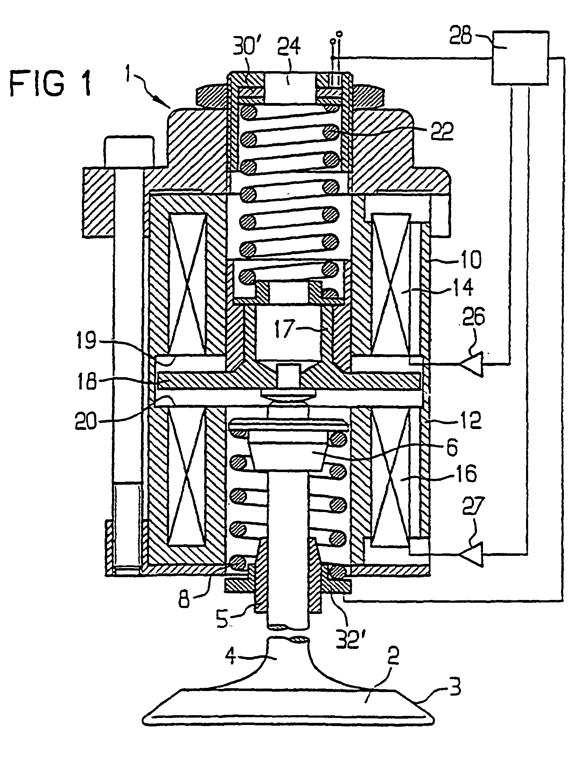

Fig. 1 zeigt ein elektromagnetisches Stellgerät 1 für ein als Tellerventil ausgebildetes Gaswechselventil, das aus einem Ventilteller 2 mit Ventilsitz 3 und einem Ventilschaft 4 besteht, der in einer gehäuseseitigen Führung 5 gelagert ist und am oberen Ende mit einem Kegelstück 6 versehen ist. Der Ventilteller wird vom Stellgerät 1 zwischen zwei Endstellungen bewegt: In einer oberen Endstellung ist das Gaswechselventil geschlossen und in einer unteren Endstellung geöffnet.

Eine zwischen der gehäuseseitigen Führung 5 und dem Kegelstück 6 angeordnete Ventilfeder 8 beaufschlagt den Ventilteller in die Schließstellung.

Das Stellgerät 1 besteht weiter aus einem oberen ferromagnetischen Spulenkörper 10 und einem unteren ferromagnetischen Spulenkörper 12, die jeweils eine Spule 14 und 16 tragen.

Innerhalb des oberen Spulenkörpers 10 ist verschiebbar ein Ankerschaft 17 gelagert, der einen plattenförmigen Anker 18 aufweist, der zwischen den beiden Spulen 14, 16 liegt. Die dem Anker 18 zugekehrten Stirnseiten 19 und 20 der beiden Spulenkörper 10 und 12 bilden Anschläge für den Anker 18 und definieren damit die obere und untere Endstellung des Gaswechselventils, in der es geöffnet bzw. geschlossen ist.

Eine Aktuatorfeder 22 ist zwischen dem Ankerschaft 17 und einem gehäuseseitigen Anschlag 24 eingespannt und beaufschlagt den Anker 18 in Richtung Öffnungsstellung des Ventiltellers 2. Der Anker 18 liegt auf dem Ventilschaft 4 auf. Solange die Spulen 14 und 16 stromlos sind, wird der Anker 18 von der Ventilfeder 8 und der Aktuatorfeder 22 in der Mittelstellung zwischen den beiden Stirnseiten 19 und 20 gehalten, wie dies in der Zeichnung dargestellt ist.

Die beiden Spulen 14 und 16 werden jeweils von einer Treiberschaltung 26, 27 bestromt, die von einer Regelschaltung 28 angesteuert werden.

Zur Messung des Hubes des Ankertellers 2 ist weiter ein Piezoelement 30' an der Aktuatorfederabstützung vorgesehen. Ein weiteres Piezoelement 32' ist an der gehäuseseitigen Führung 5 vorgesehen. Die Ausgangssignale der beiden Piezoelemente 30', 32' werden der Regelschaltung 28 zugeführt, die sie dazu verwendet, die Auftreffgeschwindigkeit des Ankers 18 auf den Spulenkörpern 10 bzw. 12 an den Stirnseiten 19 bzw. 20 so zu regeln, dass das Ventil ohne Prallen, geräuscharm, rasch und zuverlässig in die jeweilige Endstellung überführt werden kann.

In Fig, 2 ist der Strom I durch die Spule 14 bzw. 16 über der Zeit t aufgetragen. Dabei ist der Strom I durch die Spule 14 durchgezogen dargestellt, der Strom durch die Spule 16 gestrichelt. Dieser Stromverlauf wird von der Regelschaltung 28 eingestellt, um mit Hilfe einer Fangstromschaltung das Ventil ohne Prallen zuverlässig in die jeweils andere Endstellung umzuschalten. Hierzu wird der den Anker 18 in der jeweiligen Endstellung haltende Haltestrom Hs, Ho abgeschaltet, so dass der Anker von der betreffenden, sich entspannenden Feder in Richtung auf die andere Endstellung in Bewegung gesetzt wird. Gleichzeitig wird die entsprechende Wicklung 14 oder 18 mit dem Fangstrom Fo, Fs bestromt. Zum Schließen des Ventils wird die Spule 14 mit dem Fangstrom Fs bestromt. Sitzt der Anker 18 auf der Stirnseite 19 auf, so wird die Spule 14 nur noch mit niedrigerem Haltestrom Hs bestromt, der ausreicht, den Anker 18 und damit das Gaswechselventil in der geschlossenen Stellung zu halten.

Zum Öffnen des Gaswechselventils wird der Haltestrom Hs durch die Spule 14 abgeschaltet und der Fangstrom Fo durch die Spule eingeschaltet. Ist der Anker 18 unter Wirkung der Ventilfeder 8 und der Aktuatorfeder 22 sowie des durch den Fangstrom Fo erzeugten magnetischen Feldes an die Stirnseite 20 gelangt, wird die Bestromung der Spule 16 auf den Haltestrom Ho umgeschaltet und der Ventilteller 2 in der offenen Stellung gehalten. Um das Ventil wiederum zu schließen wird analog der Haltestrom Ho ab- und der Fangstrom Fs eingeschaltet.

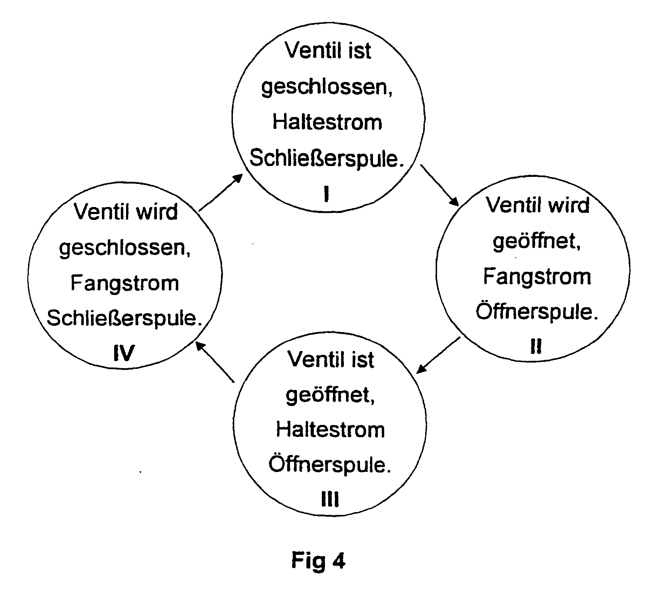

Das Gaswechselventil durchläuft also die in Fig. 4 dargestellten Zustände I bis IV. In Zustand I ist das Ventil geschlossen und in der Spule 14 fließt der Haltestrom Hs. Als nächstes wird im Zustand II das Ventil geöffnet, wozu die Spule 16 mit dem Fangstrom Fo bestromt wird und der Haltestrom Hs in der Spule 14 langsam abklingt. Ist der Anker 18 an der Stirnseite 20 angelangt, wird die Bestromung der Spule 16 auf den Haltestrom Ho umgeschaltet und das Ventil ist geöffnet (Zustand III der Fig. 4). Zum Schließen wird wiederum die Spule 14 mit Fangstrom beaufschlagt, was als Zustand IV in Fig. 4 dargestellt ist. Ist der Anker 18 an der Stirnseite 19 angelangt, liegt wieder Zustand I vor.

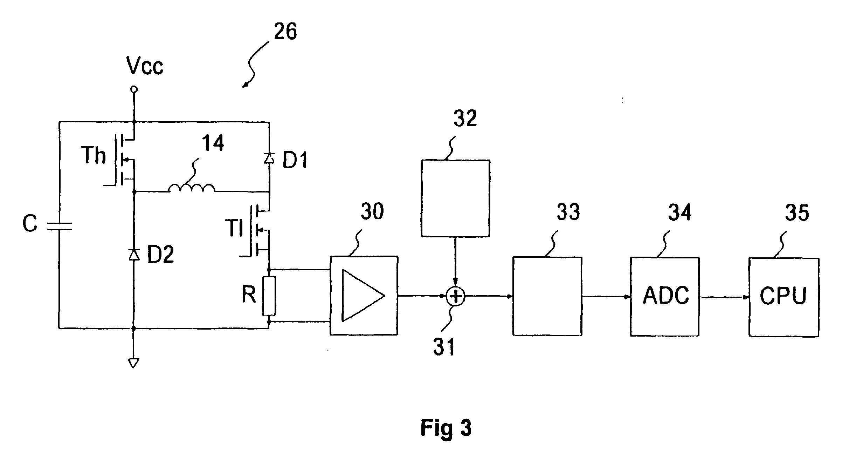

Um nun den Strom durch die Spule 14, 16 in der Regelschaltung 28 verwenden zu können, ist eine Messung des Spulenstroms erforderlich. Die dazu erforderliche Treiberschaltung ist zusammen mit einer genaueren Darstellung der Regelschaltung 28 in Fig. 3 beispielhaft dargestellt. Die Fig. 3 zeigt die Treiberschaltung 26 für die Spule 14. Die Treiberschaltung 27 ist analog ausgebildet.

Die Spule 14 wird, wie in Fig. 3 zu sehen ist, durch eine asymmetrische Halbbrücke angesteuert. Dabei ist die Spule 14 zwischen einen Highside-FET Th, der andererseits an die Versorgungsspannung Vcc angeschlossen ist, und einen Lowside-FET T1 geschaltet, der wiederum andererseits über einen Widerstand R an das Bezugspotential angeschlossen ist. Zwischen das Bezugspotential und den Verbindungsknoten der Spule 14 mit dem Highside-FET Th ist in Durchlassrichtung eine Diode D2 geschaltet. Zwischen den Verbindungsknoten der Spule 14 mit dem Lowside-FET T1 und der Versorgungsspannung Vcc ist in Durchlassrichtung eine Diode D1 geschaltet. Schließlich ist die Versorgungsspannung Vcc mit dem Bezugspotential über einen Kondensator C verbunden. Zwischen Lowside-FET T1 und dem Bezugspotential liegt ein Widerstand R.

Durch Ein- und Ausschalten des Highside- und/oder Lowside-FET Th, Tl wird ein Sollstrom in der Spule 14 eingeregelt. Dabei wird der Iststrom über den Spannungsabfall am Widerstand R im Lowsidezweig gemessen. Der Spannungsabfall wird von einem Differenzverstärker 30 abgegriffen, dessen Ausgangswert über einen Addierknoten 31 einem Filter 33 und weiter einem Analog/Digital-Wandler 34 und einem Microcontroller 35 zugeführt wird. Bei der Bestimmung des Spannungsabfalls mittels des Differenzverstärkers 30 ist ein Offsetfehler unvermeidlich, wodurch der Iststrom verfälscht ist.

Ist der Sollstrom Null, dann sperren Highside- und Lowside-FET Th, Tl. In diesem Zustand fließt kein Strom durch den Widerstand R und die Spannung am Eingang des Differenzverstärkers 30 ist Null. Aufgrund des internen Aufbaus des Differenzverstärkers 30 ist es aber möglich, das offsetfehlerbedingt am Ausgang eine negative Spannung anliegt. Bei einer unipolar aufgebauten Messkette, wie sie üblicherweise in der Kraftfahrzeugelektrik verwendet wird, ist eine negative Messspannung aber nicht erwünscht. Aus diesem Grund wird ein künstlich erzeugter Offset am Addierknoten 31 aufaddiert. Dazu wird dem Addierknoten 31 zusätzlich der Ausgang einer Konstantspannungsquelle 32 zugeführt. Somit liegt am Eingang des Filters 33 immer eine positive Spannung an.

Zur Bestimmung des Offsetfehlers muss sichergestellt sein, dass der Widerstand R nicht von einem Strom durchflossen wird. Dies kann für die Spule 14 nur in der Haltephase der anderen Spule 16 gewährleistet werden, da es sich dabei um eine Endstellung handelt, in der die Spule 14, an deren Schaltung 26 der Offsetfehler bestimmt werden soll, nicht bestromt ist. Nach Bestimmung des Offsetfehlers $I_o$ der nicht angesteuerten Spule, kann bei der nächsten Ansteuerung der Spule im darauffolgenden Zyklus der Iststrom Im wie folgt korrigiert werden:

$$I_{korr} = Im - I_o$$

Vorzugsweise wird der Offsetfehler $I_o$ in der Spule 14 mehrfach abgetastet gemessen und über die Messwerte ein gewichteter Mittelwert wie folgt gebildet:

$$I_{o,i} = I_{o,i+1} \cdot (1-k) + I_m \cdot k$$

Dieser gewichtete Mittelwert ist eine mögliche Form einer Tiefpassrealisierung; andere sind denkbar. Dabei ist $I_{o,i}$ die i-te Messung des Offsetfehlers, Im der Istwert des Stromes (Rohwert des Analog/Digitalwandlers 34) und k ein Gewichtungsfaktor.

Diese Tiefpassfilterung trägt der Erkenntnis Rechnung, dass der Offsetfehler $I_o$ temperaturbedingt fluktuiert und sich bezogen auf die Abtastrate, mit der der Offsetfehler bestimmt wird, nur langsam ändert.

Die Erfindung wurde vorstehend bei Anwendung auf ein Stellgerät 1 für ein Gaswechselventil einer Brennkraftmaschine beschrieben. Sie ist jedoch nicht darauf eingeschränkt, sondern kann auch auf andere Stellgeräte Anwendung finden. Auch muss das Stellgerät nicht zwei Spulen aufweisen, es genügt, dass eine Endstellung vorliegt, in der eine Spule nicht bestromt ist.

**Patentansprüche**

1. Verfahren zur Bestimmung des Offsetfehlers bei einer offsetbehafteten Messung des Spulenstroms eines elektromagnetischen Stellgerätes (1) mit zwei jeweils einer Endstellung, zugeordneten Spulen (14, 16), bei welchem Verfahren die offsetfehlerbehaftete Messung des Spulenstroms durch eine Spule (14, 16) dann erfolgt, wenn sich das Stellgerät (1) während des Betriebes des Stellgerätes (1) in einer Endstellung befindet, in der die Spule (14, 16) unbestromt ist, und der erhaltene Wert als Offsetfehler genommen wird,
**dadurch gekennzeichnet, daß** zum Überführen des Stellgerätes (1) in eine Endstellung, die dieser Endstellung zugeordnete Spule (14, 16) zuerst mit einem Fangstrom und dann nach Erreichen der Endstellung mit einem Haltestrom bestromt wird und dass dann die Bestimmung des Offsetfehlers an der anderen Spule (14, 16) durchgeführt wird.

2. Verfahren nach Anspruch 1, **dadurch gekennzeichnet, daß** der Spulenstrom durch Potentialabgriff vor und nach einem mit der Spule (14, 16)in Reihe geschalteten Widerstand gemessen wird, wobei die Potentialabgriffe einem Differenzverstärker (30) zugeführt werden, und zum Ausgangswert des Differenzverstärkers (30) ein konstanter Wert addiert wird, um immer ein Offsetfehlersignal bestimmter Polarität zu erhalten.

3. Verfahren nach einem der Ansprüche 1 oder 2, **dadurch gekennzeichnet, daß** der Offsetfehler $I_o$ mehrmals ermittelt und tiefpassgefiltert wird.

4. Schaltung zur Bestimmung des Offsetfehlers bei einer offsetfehlerbehafteten Messung des Spulenstroms I eines Stellgerätes mit zwei jeweils einer Endstellung (19, 20) zugeordneten Spulen (14, 16), wobei in der Zuleitung zu jeder Spule (14, 16) ein Widerstand (R) geschaltet ist, wobei zu jedem Widerstand (R) ein Differenzverstärker (30) parallel geschaltet ist, so daß die am Widerstand (R) abfallende Spannung abgreifbar ist, **dadurch gekennzeichnet, daß** die Schaltung eine Steuerschaltung (33, 34, 35) aufweist, die zur Bestromung der Spulen (14, 16) so ausgebildet ist, daß zum Überführen des Stellgerätes (1) in eine Endstellung (19, 20) die dieser Endstellung (19, 20) zugeordnete Spule (14, 16) zuerst einen Fangstrom (Fs, Fo) und dann nach Erreichen der Endstellung (19, 20) einen Haltestrom (Hs, Ho) führt, und dass die Steuerschaltung (33, 34, 35) dann den Ausgang des Differenzverstärkers (30) der anderen Spule (16, 14) auswertet.

5. Schaltung nach Anspruch 4, **dadurch gekennzeichnet, daß** der Ausgang des Differenzverstärkers (30) zusammen mit dem Ausgang eines Konstantspannungsquelle (32) einem Addierglied (31) zugeführt wird, so daß immer ein Offsetfehlersignal bestimmter Polarität vorliegt.

## Claims

1. Method for determining the offset error of a measurement that is subject to such an offset error of the coil current of an electromagnetic actuator (1) with two coils (14, 16) respectively assigned to a final position, in which method the measurement that is subject to the offset error of the coil current through a coil (14, 16) is performed when the actuator (1) is in a final position in which the coil (14, 16) is not supplied with current during the operation of the actuator (1), and the value obtained is taken as the offset error, **characterized in that**, for transferring the actuator (1) into a final position, the coil (14, 16) assigned to this final position is firstly supplied with a capture current and then, after reaching the final position, with a holding current, and **in that** then the determination of the offset error is carried out on the other coil (14, 16).

2. Method according to Claim 1, **characterized in that** the coil current is measured by potential tapping before and after a resistor connected in series with the coil (14, 16), the potential taps being fed to a differential amplifier (30), and a constant value being added to the output value of the differential amplifier (30) in order always to obtain an offset error signal of a specific polarity.

3. Method according to either of Claims 1 and 2, **characterized in that** the offset error $I_o$ is determined and low-pass-filtered several times.

4. Circuit for determining the offset error of a measurement that is subject to such an offset error of the coil current I of an actuator with two coils (14, 16), respectively assigned to a final position (19, 20), a resistor (R) being connected in the supply line to each coil (14, 16), a differential amplifier (30) being connected in parallel with each resistor (R) such that the voltage dropping across said resistor can be tapped, **characterized in that** the circuit has a control circuit (33, 34, 35) which is designed for supplying current to the coils (14, 16) in such a way that, for transferring the actuator (1) into a final position (19, 20), the coil (14, 16) assigned to this final position (19, 20) firstly carries a capture current (Fs, Fo) and then, after reaching the final position (19, 20), a holding current (Hs, Ho), and **in that** the control circuit (33, 34, 35) then evaluates the output of the differential amplifier (30) of the other coil (16, 14).

5. Circuit according to Claim 4, **characterized in that** the output of the differential amplifier (30) is fed together with the output of a constant-voltage source (32) to an adding element (31), with the result that there is always an offset error of a specific polarity.

## Revendications

1. Procédé pour déterminer l'erreur offset lors d'une mesure, sujette à un offset, du courant de bobine d'un actionneur (1) électromagnetique comprenant deux bobines (14, 16) affectées chacune à une position finale, dans lequel la mesure, sujette à une erreur offset, du courant de bobine à travers une bobine (14, 16) a lieu lorsque l'actionneur (1) se trouve, pendant le fonctionnement de l'actionneur (1), dans une position finale dans laquelle la bobine (14, 16) n'est pas alimentée, et la valeur obtenue est prise comme erreur offset,
   **caractérisé en ce que** pour amener l'actionneur (1) dans une position finale, la bobine (14, 16) affectée à cette position finale est d'abord alimentée avec un courant de capture puis avec un courant de maintien après l'arrivée en position finale et que la détermination de l'erreur offset est ensuite réalisée au niveau de l'autre bobine (14, 16).

2. Procédé selon la revendication 1,
   **caractérisé en ce que** le courant de bobine est mesuré par la prise de potentiel avant et après une résistance connectée en série avec la bobine (14, 16), dans lequel les mesures de potentiel sont envoyées à un amplificateur différenciateur (30) et une valeur constante est additionnée à la valeur de sortie de l'amplificateur différenciateur (30) afin de toujours obtenir un signal d'erreur offset d'une polarité déterminée.

3. Procédé selon l'une des revendications 1 ou 2,
   **caractérisée en ce que** l'erreur offset $I_o$ est déterminée plusieurs fois et est filtrée par un passe-bas.

4. Circuit pour déterminer l'erreur offset lors d'une mesure, sujette à un offset, du courant de bobine I d'un actionneur comprenant deux bobines (14, 16) affectées chacune à une position finale (19, 20), dans lequel une résistance (R) est connectée à chaque bobine (14, 16) dans la ligne d'alimentation, et un amplificateur différenciateur (30) est connecté en parallèle à chaque résistance (R) de telle façon que la tension en chute de la résistance (R) peut être mesurée, **caractérisé en ce que** le circuit comprend un circuit de commande (33, 34, 35) qui, pour alimenter les bobines (14, 16), est formé de telle façon que pour amener l'actionneur (1) dans une position finale (19, 20), la bobine (14, 16) affectée à cette position finale (19, 20) est traversée d'abord par un courant de capture (Fs, Fo) puis par un courant de maintien (Hs, Ho) après l'arrivée en position finale (19, 20) et que le circuit de commande (33, 34, 35) évalue ensuite la sortie de l'amplificateur différenciateur (30) de l'autre bobine (14, 16).

**5.** Circuit selon la revendication 4,
  **caractérisé en ce que** la sortie de l'amplificateur différenciateur (30) et la sortie d'une source de tension constante (32) sont reliées à un additionneur (31) afin d'avoir toujours un signal d'erreur offset d'une polarité déterminée.

FIG 1

**Fig 2**

EP 1 204 873 B1

Fig 3

Ventil ist geschlossen, Haltestrom Schließerspule.

I

Ventil wird geschlossen, Fangstrom Schließerspule.

IV

Ventil wird geöffnet, Fangstrom Öffnerspule.

II

Ventil ist geöffnet, Haltestrom Öffnerspule.

III

**Fig 4**